# EUROPEAN PATENT SPECIFICATION

(11) **EP 1 007 338 B1**
(45) Date of publication and mention of the grant of the patent: **05.09.2001**
(21) Application number: 98901428.7
(22) Date of filing: 10.02.1998
(51) Int. Cl.: B30B 1/10

(54) **SPRING ELEMENT FOR A CONNECTOR AND CONNECTOR WITH A SPRING ELEMENT**
FEDERELEMENT FÜR EIN VERBINDUNGSTÜCK UND VERBINDUNGSTÜCK MIT EINEM FEDERELEMENT
ELEMENT RESSORT POUR CONNECTEUR ET CONNECTEUR MUNI D'UN ELEMENT RESSORT

(30) Priority: 13.02.1997 EP 97102319
(43) Date of publication of application: 14.06.2000
(73) Proprietor: THE WHITAKER CORPORATION, Wilmington, Delaware 19808 (US)
(72) Inventor: DE BLIECK, Roland, Tristan, NL-5345 ET Oss (NL); BROEKSTEEG, Johannes, Marcelus, NL-5346 WJ Oss (NL); SOES, Lucas, NL-5248 BB Rosmalen (NL)
(74) Representative: Heinz-Schäfer, Marion
(86) International application number: IB9800160
(87) International publication number: WO9835821

(56) References cited:
- DE-A- 2 554 512
- GB-A- 1 172 620
- US-A- 4 054 347
- US-A- 4 466 318
- US-A- 4 968 265
- US-A- 5 254 012

## Description

The invention relates to a connector with a spring element for providing the contact force fcr making contact. Furthermore, the invention relates to a connector assembly with a connector and a complementary component, which has a contact-making area and at least one anchoring part, having a housing, which has a receiving pare for receiving and fixing the anchoring part, and having a contact block for receiving contacts and for making contact with the contact-making area, the contact block being arranged displaceably in the housing and being acted on with a spring force of a spring element, which is supported in the housing and supplies the contact force for making contact.

US-A-5,254,012 discloses a connector having a toggle device comprising two levers joined by a flexible element. The connector has a housing with a movable contact block for receiving contacts and for making contact with contact making areas. The connector is suitable for making contact with a complementary component, which has at least one anchoring part.

In many connectors, which for example have a contact block that is freely displaceable in the housing, it is necessary that this contact block is acted on with a spring force, in order to provide the contact force for making contact. Such ideas can be used for both electrical and for optical connectors or combined electrical and optical connectors. Connectors having displaceable components are particularly advantageous when two components are to be connected to each other, such as for example in the case of circuit boards to circuit board contacting means. In the case of such contacting means, it is important that the connector compensates for any play in the spacing of the circuit boards in relation to each other. In addition, when using an electrical connector having a large number of contacts, it is particularly important that the contact force for making contact is distributed uniformly over the entire length of the plug and hence to all the contacts.

It is the object of the invention to specify a connector with a spring element with which a contact force can be provided which ensures a uniform force distribution, even over a relatively great length of the connector. In addition, it is the object of the invention to specify a connector assembly with a connector and a complementary component which has appropriate spring elements. With respect to the connector with the spring element, the object is achieved by a connector with a spring element having the features of Patent Claim 1, and with respect to the connector assembly, with a connector assembly having the features of Patent Claim 6.

Advantageous developments are in each case specified in the subclaims.

The spring element can be used both in electrical and in optical connectors. This also applies to the connactor per se. In the case of use as electrical connector, a contact block has appropriate electric contacts. The connection between the first and second contact block is produced by means of electric conductors in the form of film conductors or coax conductors. A different construction of the contact block is necessary for an optical connector. This contact block then has appropriate optical "contacts", that is to say, for example, optical fibre ends for direct coupling to a contact-making area with ends of optical conductors. The connection between the contact blocks is produced by means of optical conductors, for example of an optical fibre ribbon cable.

Exemplary embodiments of the invention are now to be explained using the figures, in which;
Figure 1 shows a connector between two circuit boards in an exploded illustration;
Figure 2 shows a corresponding connector in a three-dimensional view before contact is made;
Figure 3 shows a perspective view of the plug-in face side of the connector;
Figure 4 shows a top view of the connector before contact is made;
Figure 5 shows a three-dimensional illustration corresponding to Figure 4;
Figure 6 shows a first step when connecting the two circuit boards;
Figure 7 shows a corresponding three-dimensional view;
Figure 8 shows a second step when connecting the two circuit boards;
Figure 9 shows a corresponding three-dimensional view;
Figure 10 shows the last step before contact is finally made;
Figure 11 shows a corresponding three-dimensional view;
Figure 12 shows a top view of the connector in a stage in which the contact force is being built up;
Figure 13 shows a corresponding perspective view;
Figure 14 shows a top view of the connector with the contact made;
Figure 15 shows a corresponding perspective view;

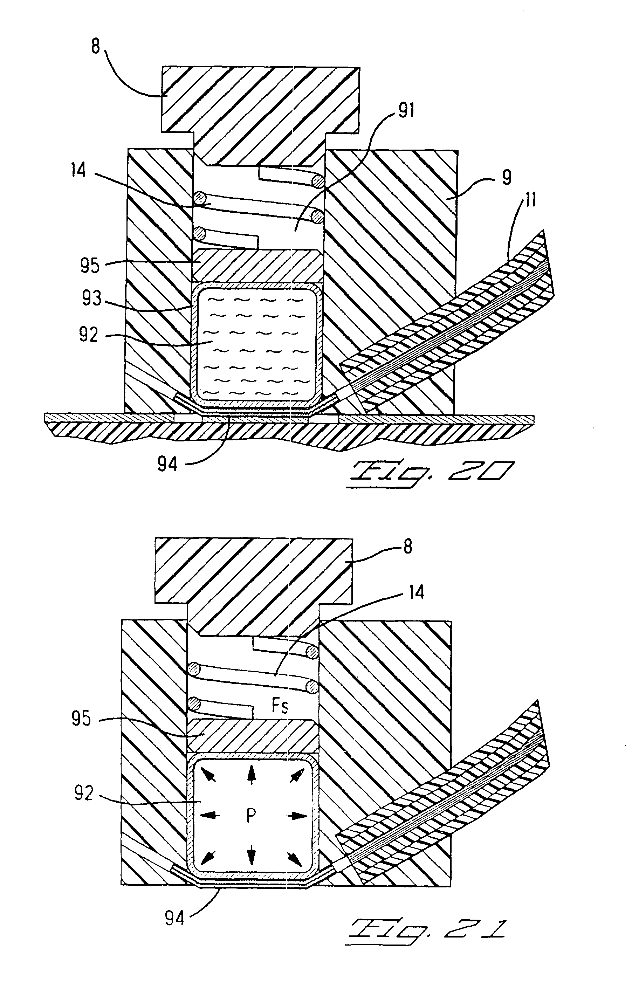

Figure 16 shows a top view of the electrical connector during the first step for releasing the contact;
Figure 17 shows a corresponding perspective view;
Figure 18 shows a top view of the connector during the second step for opening the connection;
Figure 19 shows a corresponding perspective view;
Figure 20 shows a cross-section through a possible contact block, which is built up from an incompatible fluid with an appropriate spring element, in the unloaded state;
Figure 21 shows the contact block in the compressed state;
Figure 22 shows a longitudinal cross-section through the corresponding contact block and the spring element; and

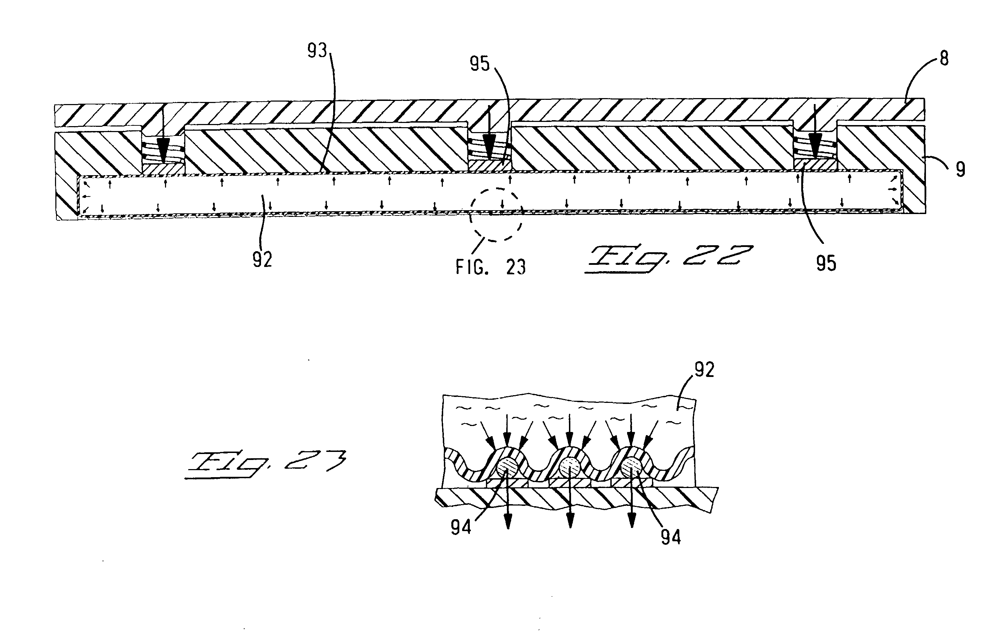

Figure 23 shows a detailed partial view from Figure 22.

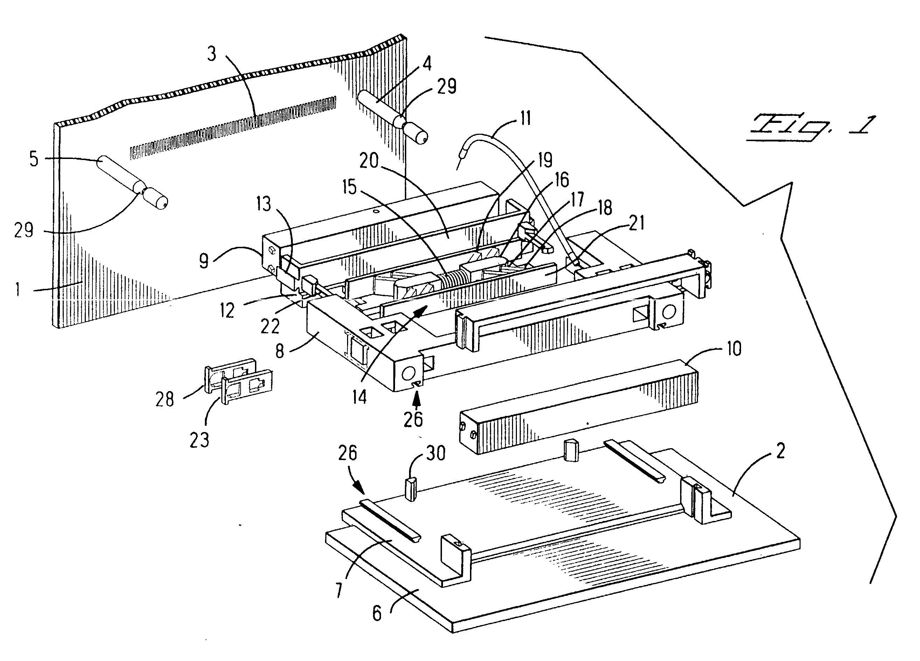

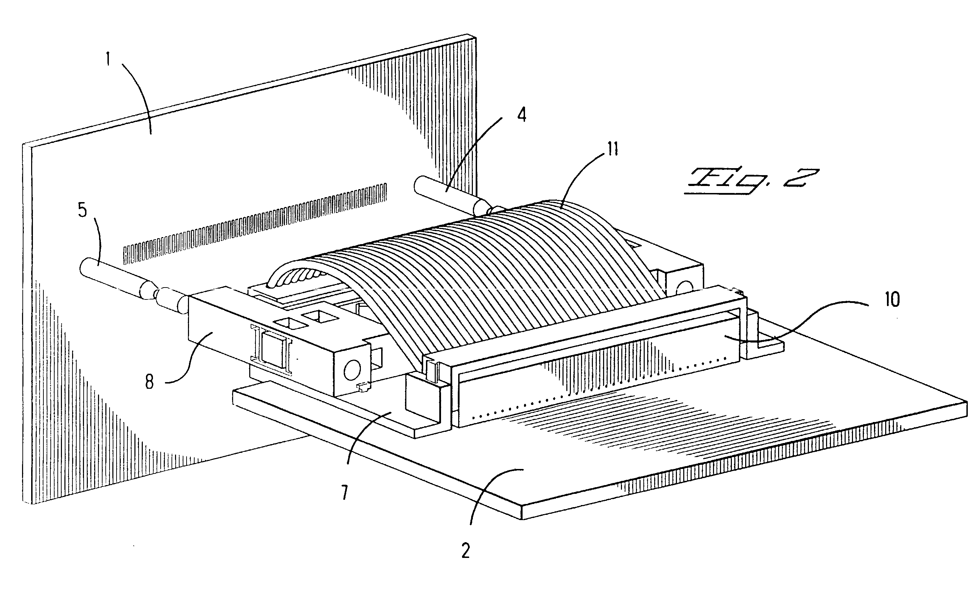

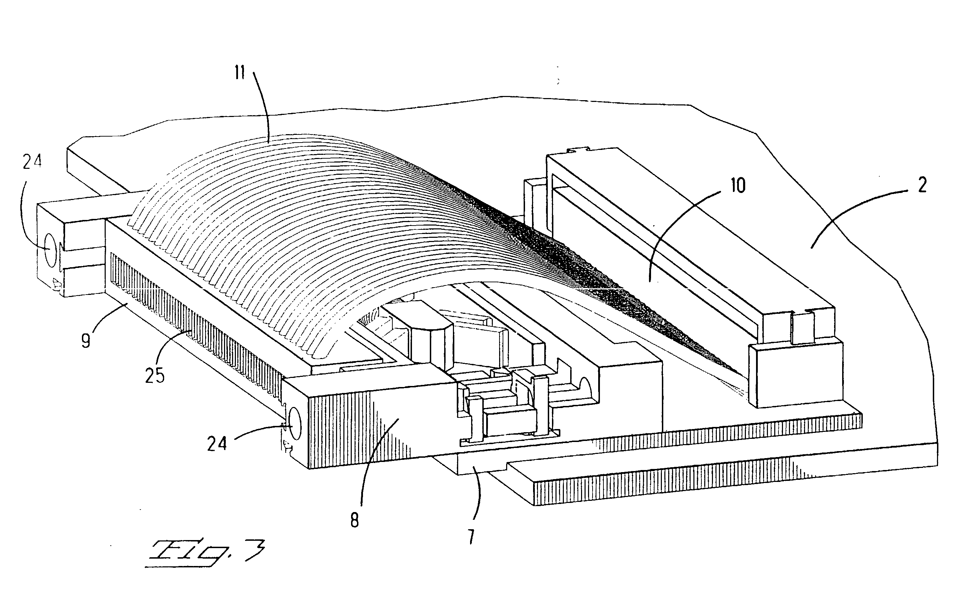

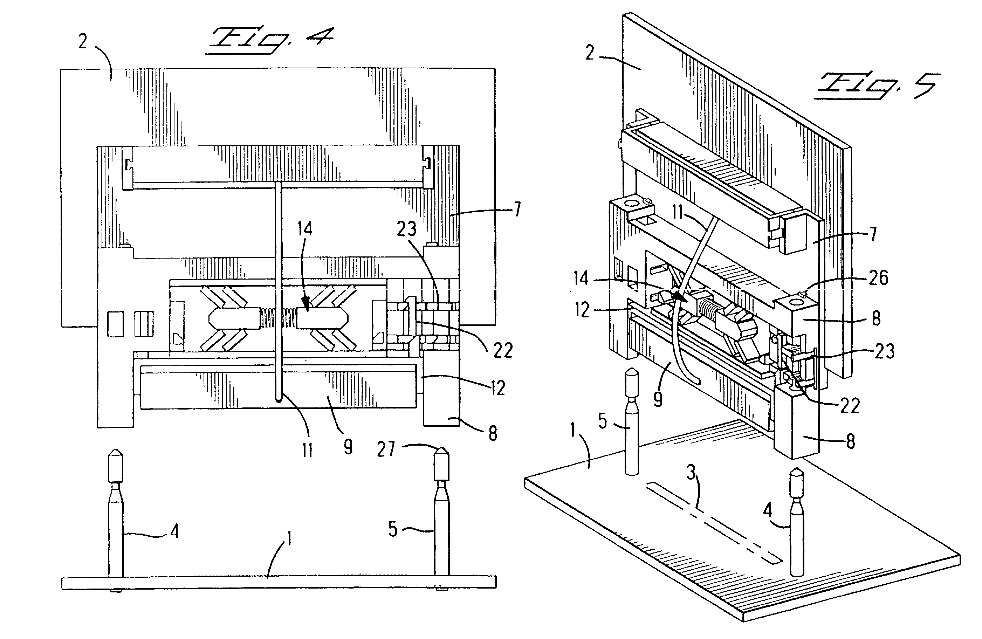

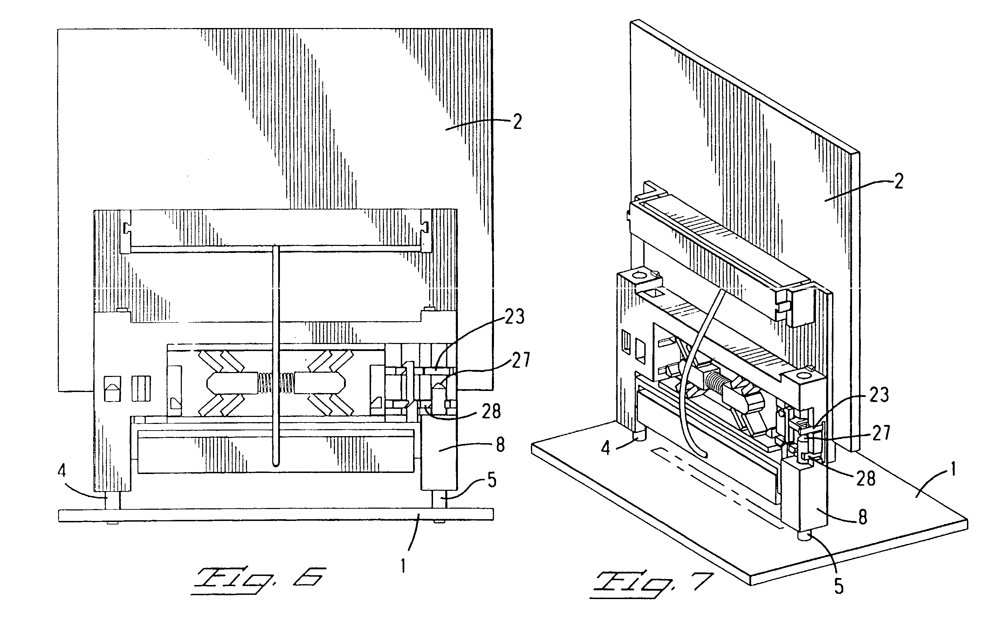

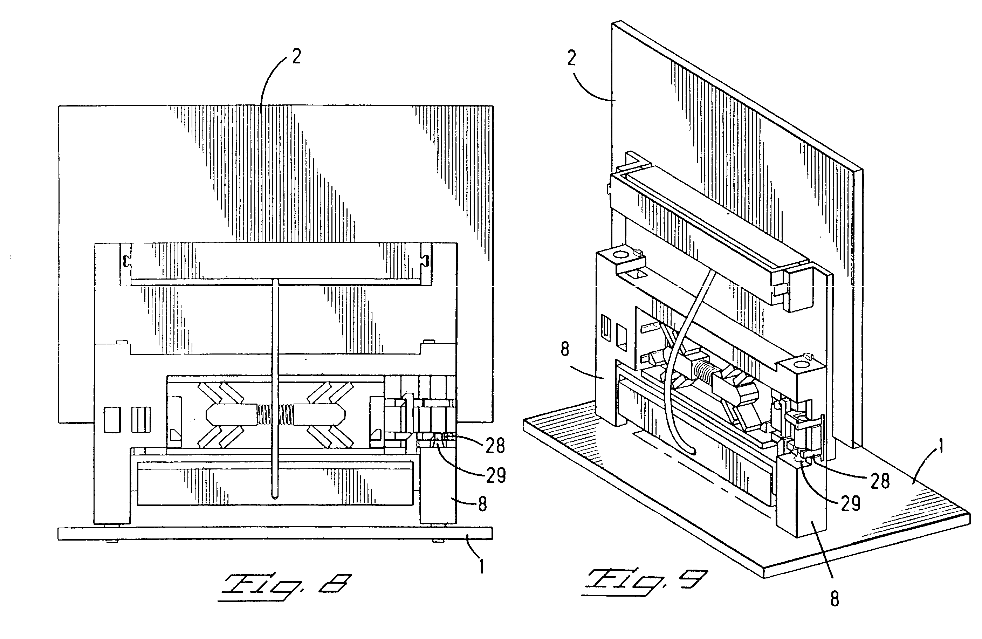

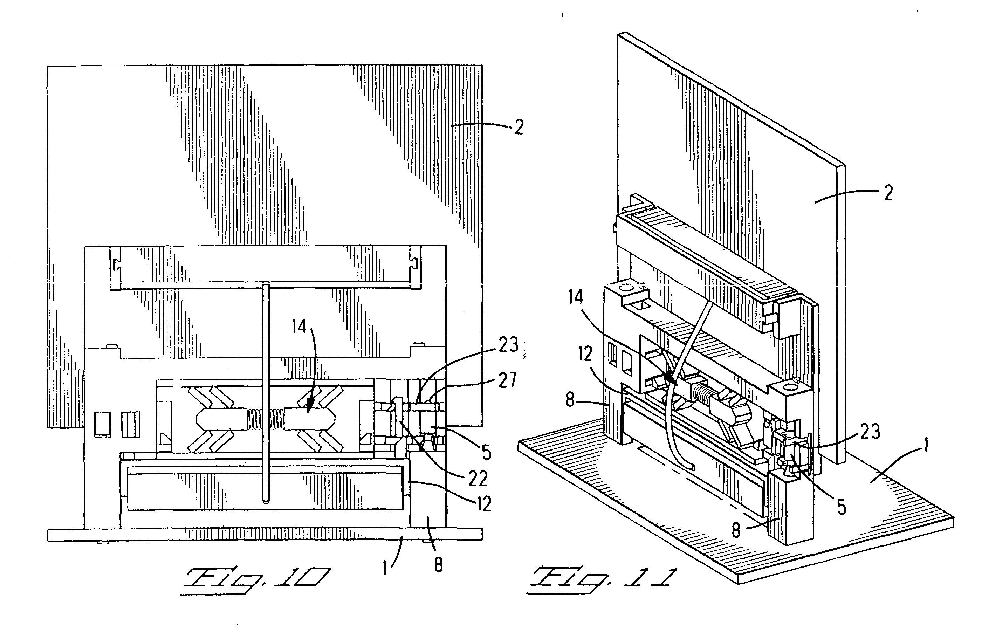

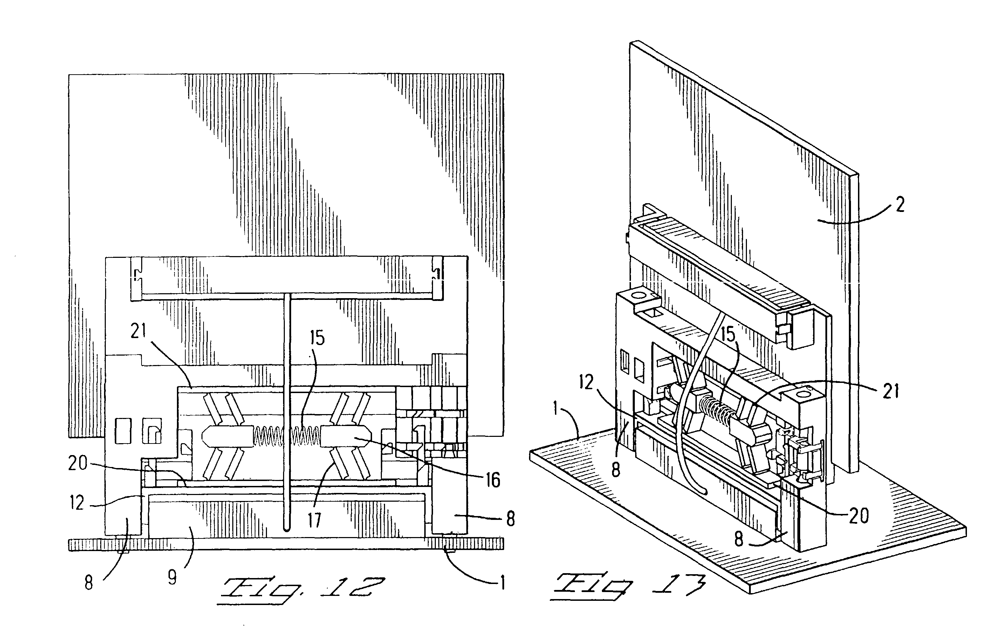

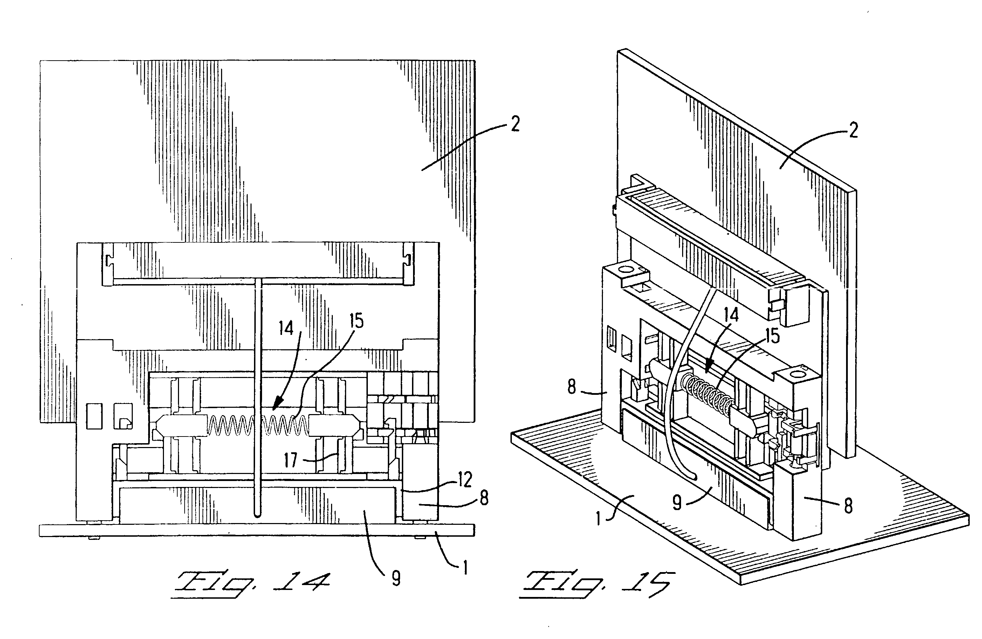

Figure 1 shows the electrical connector in an exploded illustration. It is possible to see the two circuit boards 1 and 2 that are to be connected to each other, the first circuit board 1, which represents the complementary component, having a contact-making area 3 and two anchoring parts 4, 5, which project vertically in the form of pins out of the circuit board 1. The second circuit board 2 has a surface 6. On this surface there is a base plate 7, on which the actual connector is mounted. The connector has a housing 8, in which a contact block 9 is arranged. A further contact block 10 is provided. While the contact block 9 produces the contact with the contact-making area 3 of the first circuit board 1, the contact block 10 produces the contact with the electric conductors of the circuit board 2. The connection between the two contact blocks 9 and 10 is produced by an arrangement of electric conductors 11. The contact block 9 is mounted on a slide 12, which is in turn arranged in the housing 8 such that it is freely displaceable in the plug-in direction over a small distance. A dovetail 13 is provided for guidance. A spring element 14 is provided between the slide 12 and the housing 8. The spring element 14 provides the contact force for making contact. It is supported on one side against the housing 8 and acts on the slide 12. The actual spring force is provided by a spring, here a spiral spring 15, whose spring force is oriented perpendicular to the plug-in direction. In addition, the spring element 14 has two toggle levers 17, which are connected to each other in the toggle joint 16, on each side of the spiral spring 15. The toggle levers, which are arranged on opposite sides of the spiral spring 15, operate in the opposite direction. The free ends of the toggle levers 18, 19 are each articulated to a plate 20, 21. The plate 20, on the plug-in face side, acts on the slide 12, whereas the plate 21 is supported in the housing 8. Provided between the slide 12 and the housing 8 is a latching structure, which comprises appropriate latching arms 22 on the slide 12 and catches 23, 28. The way in which this latching structure acts will be explained using the following figures.

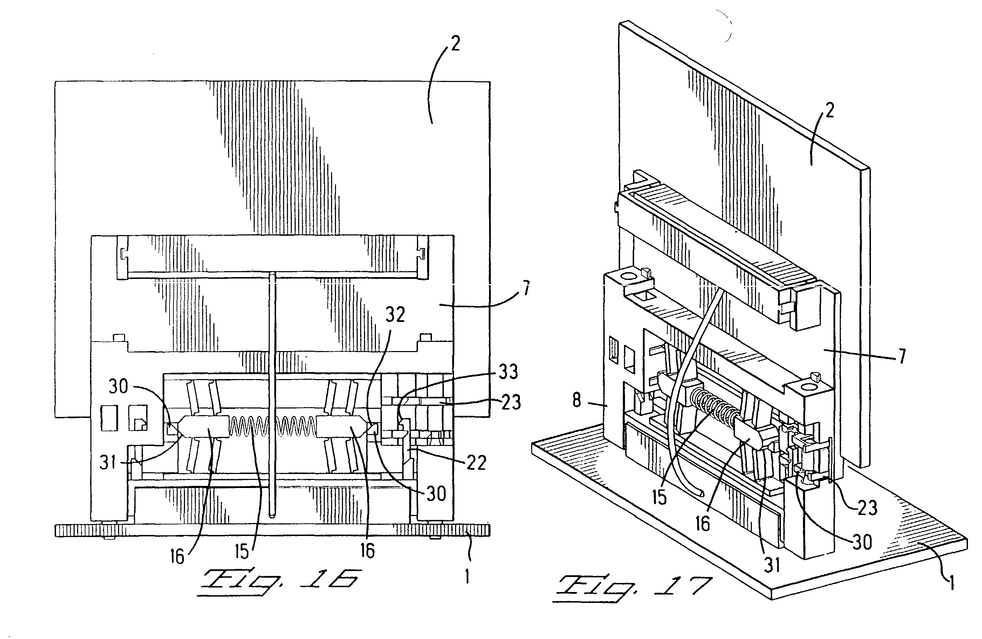

For the purpose of better clarity, only a single conductor of the arrangement of electric conductors 11 is illustrated in Figure 1. As can be seen, for example from Figures 2 and 3, the arrangement of electric conductors 11 has a relatively large number of electric conductors which are arranged parallel to one another, for example in the form of a ribbon cable. They extend from the contact block 9 for making contact with the first circuit board 1 as far as the contact block 10 for making contact on the circuit board 2. It is particularly advantageous here to use coaxial conductors. Instead of individual pieces of extruded coaxial conductors, which then in turn have to be stripped at their ends, it also transpires to be particularly advantageous to produce a ribbon structure which is produced not by extruding the individual conductors but by extrusion-coating an appropriate ribbon of an appropriate shape and length. This also makes stripping the ends of the corresponding structure unnecessary. The use of film conductors is also particularly advantagecus.

In the description of the following figures identical reference symbols are used for identical parts. Figure 2 gives a fundamental impression of the construction of the overall structure. The receiving parts 24 for receiving and fixing the anchoring parts 4, 5 are clearly to be seen in Figure 3. In addition, the electric contacts 25 in the contact block 9 can clearly be seen.

In Figures 4 and 5, the electrical connector is shown in a top view and, respectively, in a corresponding perspective illustration. Here, once more only a single cable of the arrangement of electric conductors 11 is illustrated, in order to obtain appropriately high clarity. The spring of the spring element 14 is in the tensioned state. In this position, the slide 12 is latched to the contact block 9 in the housing 8. The latching takes place as a result of the fact that the latching arm 22 is latched by the catch 23 that is further removed from the plug-in face. This latching prevents the spring element from expanding already in this state. The housing 8 can move in the plug-in direction over the base plate 7, on which it is guided by means of a dovetail arrangement 26. The latter can also be particularly clearly seen in Figure 1. If the two circuit boards 1 and 2 are now moved towards each other, the anchoring parts 5 are introduced into the corresponding receiving parts of the housing 8. The bevel 27 at the free end of the anchoring parts will move the first catch 28 in the housing, on the plug-in face side, to the side. This is illustrated in Figures 6 and 7.

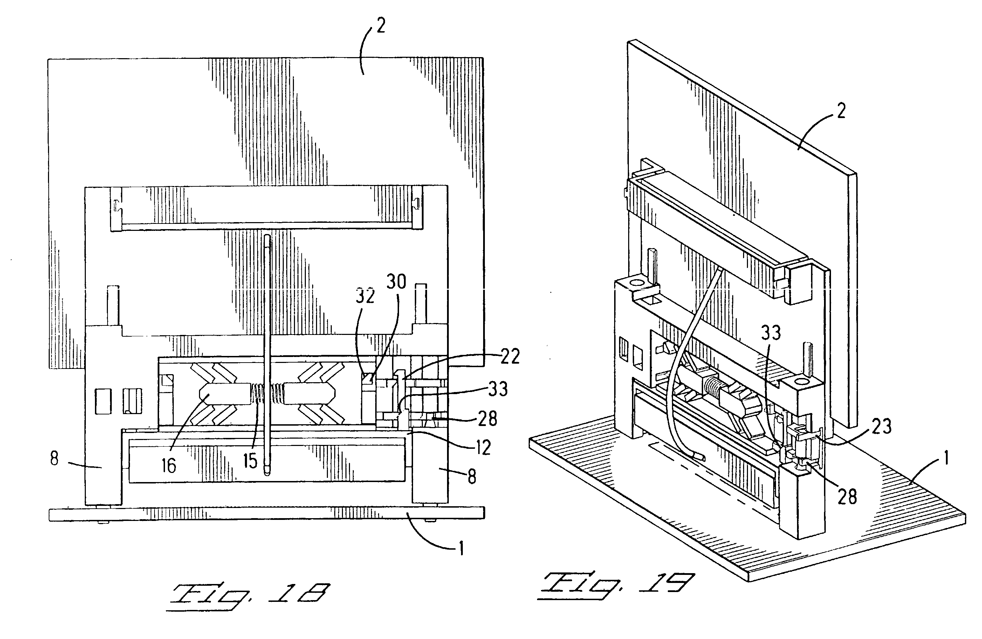

As can be seen from Figures 8 and 9, the anchoring parts 4, 5 are pushed into the receiving parts 24 by the further movement of the circuit boards 1 and 2 towards each other. The anchoring parts 4, 5 have tapered regions 29, as can already be seen, for example, from Figure 1. If these tapered regions 29 enter the region of the catch 28, the latter is pushed back by a corresponding spring part into the tapered region 29 of the anchoring part 4, 5. The catch 28 therefore locks the anchoring parts 4, 5 in the housing 8, as a result of which the housing 8 is anchored in relation to the first circuit board 1. However, in this state the contact has not yet been produced.

As is illustrated in Figures 10 and 11, the housing 8 is moved further towards the circuit board 1 by further moving the two circuit boards 1, 2 towards each other. As a result, the bevel 27 of the anchoring part 5 penetrates into the region of the catch 23, and pushes the latter to the side. The plug-in face side end of the housing 8 at the same time strikes against the circuit board 1. When the catch 23 has been pressed to the side, the latching arm 22 is freely movable. The compressed spring element 14 will then move the slide towards the circuit board 1, since the slide 12 is no longer latched to the housing 8.

As is illustrated in Figures 12 and 13, the spiral spring 15 will expand and thus move apart and, in so doing, cause the toggle-lever arrangement to stretch the limbs of the individual toggle levers. As a result of this stretching, the two plates 20 and 21 are pressed away from each other, and thus the slide is pushed towards the front end of the housing. The front face of the contact block 9 then makes contact with the circuit board 1. The spring 15 will expand until the limbs of the toggle levers 17 are aligned parallel to each other, that is to say are therefore aligned perpendicular to the plates 20 and 21. This state is illustrated in Figure 14. Before the toggle levers 17 reach this position, the contact force is built up. In the perpendicular position of the toggle levers, a pressure in the plug-in direction will not lead to the spring element 14 being compressed once more. A blocking position is thus once more reached. It is important to emphasize that the point at which the latching between the slide 12 and the housing 8 is cancelled depends simply and solely on the dimensioning of the anchoring parts 4, 5, but not on the length or the tolerances of the circuit board 2.

The connection which is finally set up is illustrated in Figures 14 and 15. The spiral spring 15 of the spring element 14 is in its expanded position. In order to open the connection that has been built up, the circuit board 2 is then removed from the circuit board 1. At the same time, the projections 37 on the base plate 7 (see also Figure 1) will move along the bevelled surface 38 of the toggle lever 16, and transfer the toggle lever 17 from the perpendicular position into a slightly inclined position. It is then once more possible to actuate the toggle levers 17 and, as a result, to compress the spring 15. The projections 37 then run up against the surface 32 of the slide 12 and move the slide 12 away from the circuit board 1, the spring element 14 being compressed once more. The catch 23 is pushed to the side by the bevelled face 33 on the upper side of the latching arm 22. The catch 23 is pushed back by a spring part into the blocking position as soon as it has been passed by the hook of the latching arm 22, and the slide 12 is thus once more latched to the housing 8. The slide is pushed further back by further tension on the circuit board 2. A further inclined face 33 on the latch arm 22 will then push the catch 28 to the side and thus release the latching between the catch and the tapered region 29 of the anchoring part: 4, 5. The latching between the housing 8 and anchoring parts 4, 5 of the circuit board 1 is released thereby, and the circuit boards 1, 2 with the connector can be separated from each other.

In order to ensure the most uniform pressure of the contacts of the contact block on the corresponding contact-making area, it is expedient to use a spring element having a quite special construction. This can be performed, for example, in that a spring element, as described in the previous figures, which comprises a spiral spring and corresponding toggle levers, is combined with a chamber which is filled with an incompressible fluid that is surrounded by a diaphragm and acts on the electric contacts.

The following description does not relate to the claimed invention, as the described spring element is not corresponding to the subject-matter of the independent claims.

The construction of a contact block having an incompressible fluid 92 will now be described using Figures 20 to 21. The contact block 9 has a chamber 91. The chamber is filled, at least in part, with an incompressible fluid 92. The fluid 92 is surrounded by a diaphragm 93. The diaphragm 93 acts directly on the ends of the electric conductors 11, that is to say on the contacts 94. In order to build up the contact force, use is made of a different spring element 14, which is illustrated schematically in Figure 20 and acts on the diaphragm 93 via a pressure plate 95. In this case, the spring element 14 is arranged between the housing and the pressure plate 95. If an appropriate pressure is exerted on the pressure plate 95 by the spring element 14, then this pressure will be distributed uniformly in the fluid 92, and a corresponding uniform pressure distribution will be produced on the contact 94. The fluid 92, which is surrounded by the diaphragm 93, will therefore distribute the pressure uniformly onto the contacts 94 in accordance with the theory of communicating vessels.

## Claims

1. Connector with a spring element, for providing the contact force for making contact, the spring element (14) having two toggle levers (17) with a toggle joint (16), which are connected to each other at the toggle joint (16) by a spring (15) and operate in opposite directions.

2. Connector according to Claim 1, **characterised in that** the free ends (18, 19) of the toggle levers (17) are connected on one side to a contact block (9) and on the other side to a plug housing (8), and the contact block (9) is arranged displaceably in the plug housing (8).

3. Connector according to either of Claims 1 and 2, **characterised in that** the spring (15) is a spiral spring.

4. Connector according to either of Claims 1 and 3, **characterized in that** the spring element (14) has at least two toggle levers (17), which operate in the same direction; on each side of the spring (15).

5. Connector according to one of Claims 1 to 4, **characterized in that** the free ends (18, 19) of the toggle levers (17) are articulated on a plate (20, 21).

6. Connector assembly with a connector and a complementary component (1), which has a contact-making area (3) and at least one anchoring part (4, 5), the connector having a housing (8), which has a receiving part (24) for receiving and fixing the anchoring part (4, 5), and having a contact block (9) for receiving contacts (25) and for making contact with the contact-making areas (3), the contact block being arranged displaceably in the housing (8) and being acted on with a spring force of a spring element (14), which is supported in the housing (8) and supplies the contact force for making contact, wherein the spring element (14) has two toggle levers (17), which are connected to each other at the toggle joint (16) by a spring (15) and operate in opposite directions in such a way that when the spring (15) is expanded the contact block (9) moves towards the contact-making area.

7. Connector assembly according tc Claim 6, **characterized in that** the spring (15) is a spiral spring.

8. Connector assembly according to either of Claims 6 and 7, **characterized in that** the spring element (14) has at least two toggle levers (17), which operate in the same direction, on each side of the spring (15).

9. Connactor assembly according to one of Claims 6 to 8, **characterized in that** the housing (8) and the contact block (9) are detachably connected to each other in such a way that the contact block (9) only makes contact with the contact-making area (3) when the anchoring part (5) is fixed in the receiving part (24).

## Patentansprüche

1. Verbinder mit einem Federelement für das Bereitstellen der Kontaktkraft zur Herstellung eines Kontaktes, wobei das Federelement (14) zwei Kniehebel (17) mit einem Kniegelenk (16) aufweist, die miteinander im Kniegelenk (16) mittels einer Feder (15) verbunden sind und in entgegengesetzten Richtungen funktionieren.

2. Verbinder nach Anspruch 1, **dadurch gekennzeichnet**, daß die freien Enden (18, 19) der Kniehebel (17) an einer Seite mit einem Kontaktblock (9) und an der anderen Seite mit einem Steckergehäuse (8) verbunden sind, und daß der Kontaktblock (9) verschiebbar im Steckergehäuse (8) angeordnet ist.

3. Verbinder nach einem der Ansprüche 1 und 2, **dadurch gekennzeichnet**, daß die Feder (15) eine Spiralfeder ist.

4. Verbinder nach einem der Ansprüche 1 und 3, **dadurch gekennzeichnet**, daß das Federelement (14) mindestens zwei Kniehebel (17) auf jeder Seite der Feder (15) aufweist, die in der gleichen Richtung funktionieren.

5. Verbinder nach einem der Ansprüche 1 bis 4, **dadurch gekennzeichnet**, daß die freien Enden (18, 19) der Kniehebel (17) an einer Platte (20, 21) gelenkig befestigt sind.

6. Verbinderanordnung mit einem Verbinder und einem komplementären Bauteil (1), das eine Kontaktgabefläche (3) und mindestens ein Verankerungsteil (4, 5) aufweist, wobei der Verbinder aufweist: ein Gehäuse (8), das einen Aufnahmeteil (24) für das Aufnehmen und Befestigen des Verankerungsteils (4, 5) aufweist; und einen Kontaktblock (9) für das Aufnehrnen von Kontakten (25) und zur Herstellung eines Kontaktes mit den Kontaktgabeflächen (3), wobei der Kontaktblock verschiebbar im Gehäuse (8) angeordnet ist, und wobei auf ihn eine Federkraft eines Federelementes (14) wirkt, das im Gehäuse (8) gehalten wird und die Kontaktkraft zur Herstellung des Kontaktes liefert, worin das Federelement (14) zwei Kniehebel (17) aufweist, die miteinander im Kniegelenk (16) mittels einer Feder (15) verbunden sind und in entgegengesetzten Richtungen so funktionieren, daß sich, wenn die Feder (15) ausgedehnt wird, der Kontaktblock (9) zur Kontaktgabefläche hin bewegt.

7. Verbinderanordnung nach Anspruch 6, **dadurch gekennzeichnet**, daß die Feder (15) eine Spiralfeder ist.

8. Verbinderanordnung nach einem der Ansprüche 6 und 7, **dadurch gekennzeichnet**, daß das Federelement (14) mindestens zwei Kniehebel (17) auf jeder Seite der Feder (15) aufweist, die in der gleichen Richtung funktionieren.

9. Verbinderanordnung nach einem der Ansprüche 6 bis 8, **dadurch gekennzeichnet**, daß das Gehäuse (8) und der Kontaktblock (9) lösbar miteinander so verbunden sind, daß der Kontaktblock (9) erst einen Kontakt mit der Kontaktgabefläche (3) herstellt, wenn das Verankerungsteil (5) im Aufnahmeteil (24) befestigt ist.

## Revendications

1. Connecteur comportant un élément de ressort pour établir la force de contact en vue de l'établissement d'un contact, l'élément de ressort (14) comportant deux leviers à genouillère (17) avec une genouillère (16), connectés l'un à l'autre au niveau de la genouillère (16) par un ressort (15) et agissant dans des directions opposées.

2. Connecteur selon la revendication 1, **caractérisé en ce que** les extrémités libres (18, 19) des leviers à genouillère (17) sont connectées sur un côté à un bloc de contact (9) et sur l'autre côté à un boîtier de fiche (8), le bloc de contact (9) étant agencé de manière mobile dans le boîtier de fiche (8).

3. Connecteur selon les revendications 1 ou 2, **caractérisé en ce que** le ressort (15) est un ressort spiralé.

4. Connecteur selon l'une des revendications 1 ou 3, **caractérisé en ce que** l'élément de ressort (14) comporte au moins deux leviers à genouillère (17), agissant dans la même direction, de chaque côté du ressort (15).

5. Connecteur selon l'une des revendications 1 à 4, **caractérisé en ce que** les extrémités libres (18, 19) des leviers à genouillère (17) sont fixées par articulation sur une plaque (20, 21).

6. Assemblage de connecteur comportant un connecteur et un composant complémentaire (1), comportant une zone d'établissement d'un contact (3) et au moins une partie de fixation (4, 5), le connecteur comportant un boîtier (8), comportant une partie de réception (24) destinée à recevoir et à fixer la partie de fixation (4, 5) et comportant un bloc de contact (9) destiné à recevoir les contacts (25) et à établir un contact avec les zones d'établissement d'un contact (3), le bloc de contact étant agencé de manière mobile dans le boîtier (8) et étant exposé à une force de ressort d'un élément de ressort (14), supporté dans le boîtier (9) et établissant la force de contact pour établir le contact, l'élément de ressort (14) comportant deux leviers à genouillère (17), connectés l'un à l'autre au niveau de la genouillère (16) par un ressort (15) et agissant dans des directions opposées, de sorte que lorsque le ressort (15) est détendu, le bloc de contact (9) se déplace vers la zone d'établissement du contact.

7. Assemblage de connecteur selon la revendication 6, **caractérisé en ce que** le ressort (15) est un ressort spiralé.

8. Assemblage de connecteur selon l'une des revendications 6 et 7, **caractérisé en ce que** l'élément de ressort (14) comporte au moins deux leviers à genouillère (17) agissant dans la même direction, de chaque côté du ressort (15).

9. Assemblage connecteur selon l'une des revendications 6 à 9, **caractérisé en ce que** le boîtier (8) et le bloc de contact (9) sont connectés de manière amovible l'un à l'autre, de sorte que le bloc de contact (9) n'établit un contact avec la zone d'établissement d'un contact (3) que lorsque la partie de fixation (5) est fixée dans la partie de réception (24).
